Europäisches Patentamt

European Patent Office

Office européen des brevets

(11) Publication number: **0 115 128**
**B1**

(12) **EUROPEAN PATENT SPECIFICATION**

(45) Date of publication of patent specification: **25.05.88**

(21) Application number: **83307215.0**

(22) Date of filing: **25.11.83**

(51) Int. Cl.⁴: **G 11 C 8/00, G 11 C 7/00,**
**G 11 C 5/02, G 11 C 11/24**

(54) Block-divided semiconductor memory device.

(30) Priority: **04.12.82 JP 212085/82**

(43) Date of publication of application:
**08.08.84 Bulletin 84/32**

(45) Publication of the grant of the patent:
**25.05.88 Bulletin 88/21**

(84) Designated Contracting States:
**DE FR GB**

(56) References cited:
**US-A-3 942 164**

**PATENTS ABSTRACTS OF JAPAN, vol. 6, no. 5
(P-97) 883r, 13th January 1982;
PATENTS ABSTRACTS OF JAPAN, vol. 1, no.
35, 15th April 1977, page 1860 E 76;**

(73) Proprietor: **FUJITSU LIMITED**
**1015, Kamikodanaka Nakahara-ku
Kawasaki-shi Kanagawa 211 (JP)**

(72) Inventor: **Baba, Fumio Miyamaedaira Gurin-
haitsu 48-303
430, Mukogaoka Miyamae-ku
Kawasaki-shi Kanagawa 213 (JP)**

(74) Representative: **Rackham, Stephen Neil et al
GILL JENNINGS & EVERY 53-64 Chancery Lane
London WC2A 1HN (GB)**

## Description

The present invention relates to a semiconductor memory device having memory cells divided into a plurality of separated blocks.

In recent years, dynamic metal-oxide semiconductor (MOS) random access memory (RAM) devices have been enlarged to 64 kbits, or to be exact 65,536 bits. As the integration density has become higher, the number of memory cells connected to one sense amplifier for the read operation has become higher and, accordingly, the load of each sense amplifier has also become higher so reducing the speed of the read operation. To reduce the load, for example, in a prior 64 kbits MOS RAM device, two series of sense amplifiers are provided. That is, the memory cells, sense amplifiers, row address decoders, and the like are divided into two blocks, each servicing 32 kbits.

Further, as the integration density has become higher, the pitch in the column direction, i.e. the pitch of the bit lines, has also become smaller, while, column address decoders have become larger due to the increase of the number of address bits. As a result, it becomes difficult to arrange for one column address decoder for each bit line pair. Therefore, it has been proposed to arrange one column address decoder for every two bit line pairs, four bit line pairs, or so on. In this case, two sense line pairs, four sense line pairs, or the like are provided for each block. Of course, decoders for selecting such sense line pairs are necessary, however, such decoders are separated from the block-divided elements and, accordingly, the presence of such decoders hardly reduces the integration density.

In a prior art block-divided device in which one column decoder is provided for two or more bit line pairs, i.e., two or more sense line pairs are provided for each block, the arrangement of sense lines is the same in all the blocks. As a result, when a write operation is performed upon a first pair of sense lines, and simultaneously, a read operation is performed upon a second pair of sense lines adjacent the first pair of sense lines, noises generated from the first pair of sense lines are superposed on each line of the second pair of sense lines due to the capacitive coupling between close lines and impurity diffusion regions. As a result, the read operation from the second pair of sense lines may be incorrectly carried out. Note that a read operation carried out simultaneously with a write operation, i.e., a read operation during the write access mode, is a so-called refresh operation. Such a refresh operation is also carried out during the read access mode, and in addition, is independently carried out during a no acces mode, i.e., during the refresh mode. At any rate, particularly, in a read operation carried out simultaneously with a write operation, the noise applied to the sense lines is extremely large.

The aim of the present invention is to provide a block-divided semiconductor memory device comprising:

a plurality of word lines;

a plurality of pairs of bit lines;

memory cells each provided at an intersection of the word lines and the bit lines, the memory cells being divided into a plurality of blocks separated from each other;

a plurality of pairs of sense lines provided for each of the blocks, each pair receiving two complementary signals;

a first selecting means, for selecting one word line from the word lines;

a second selecting means for selecting a plurality of pairs of bit lines from the bit lines belonging to each block, and to connect the selected pairs of bit lines to the pairs of sense lines of the corresponding block; and,

a third selecting means for selecting one pair from the pairs of sense lines, in which a correct read operation can be carried out simultaneously with a write operation.

According to the present invention this is achieved by having the sense relationship between the two adjacent sense lines belonging to one block opposite to the sense relationship between the corresponding two adjacent sense lines belonging to the other block to which they are directly connected. As a result, noises from the first pair of sense lines are applied to the second pair of sense lines and the noises induced in the first and second pairs are of opposite sense and so tend to cancel one another out.

Particular embodiments of devices in accordance with this invention will now be described with reference to the accompanying drawings; in which:—

Figure 1 is a block circuit diagram of a first embodiment of the block-divided semiconductor memory device;

Figures 2A and 2B are partial block circuit diagrams of the first embodiment;

Figure 3 is a block circuit diagram of a second embodiment of the block-divided semiconductor memory device;

Figures 4A and 4B are partial block circuit diagrams of the second embodiment;

Figure 5 is a block circuit diagram of a third embodiment of the block-divided semiconductor memory device; and

Figures 6A and 6B are partial block circuit diagrams of the third embodiment.

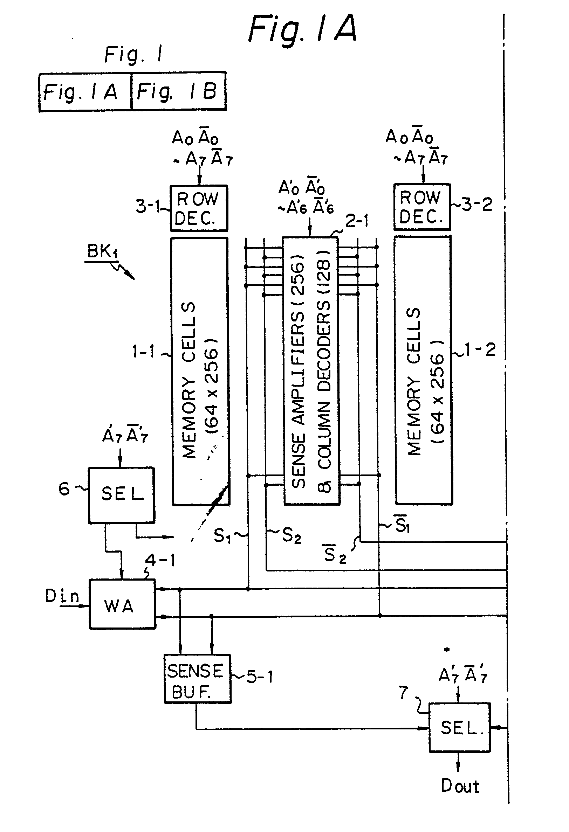

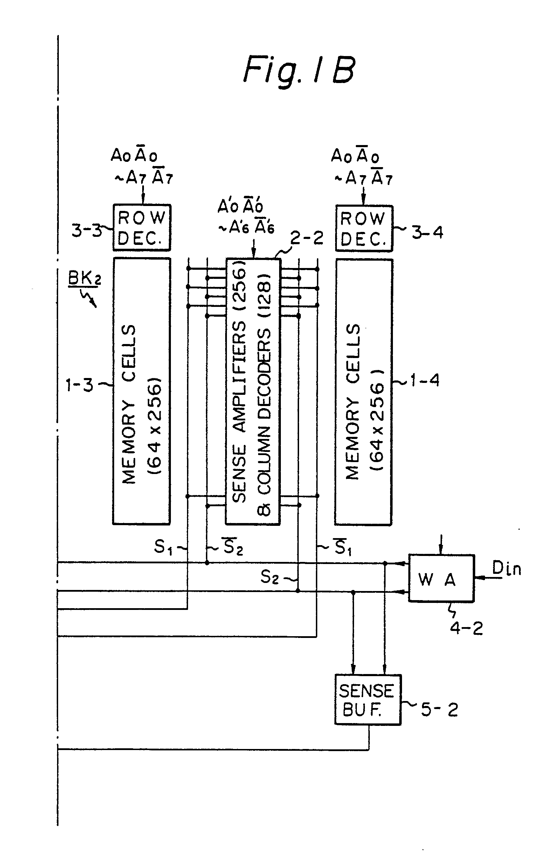

In Figure 1, which illustrates a first embodiment of the present invention, 64 kbit memory cells are divided into four 16 kbit memory cell arrays 1-1, 1-2, 1-3, and 1-4. A sense amplifier/column address decoder portion 2-1 is arranged between the memory cells arrays 1-1 and 1-2, and a sense amplifier/column address decoder portion 2-2 is arranged between the memory cell arrays 1-3 and 1-4. Row address decoders 3-1 through 3-4 respond to row address signals $A_0$ and $\bar{A}_0$ through $A_7$ and $\bar{A}_7$ to select one word line from 256 word lines (not shown) within the entire memory cell arrays 1-1 through 1-4. Therefore, the memory cell arrays 1-1 and 1-2, the sense amplifier/column address decoder portion 2-1, the row address decoders 3-1 and 3-2, and the like form a first block $BK_1$, while the memory cell arrays 1-3 and 1-4, the sense amplifier/column decoder portion 2-2, the row address decoders 3-3 and 3-4, and the like form a second block $BK_2$. Thus, two series of sense amplifiers are provided, thereby reducing the load thereof.

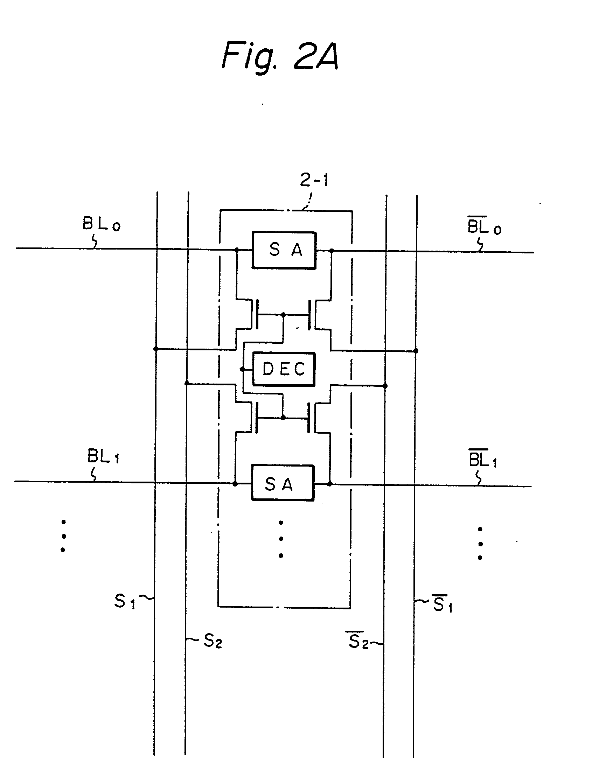

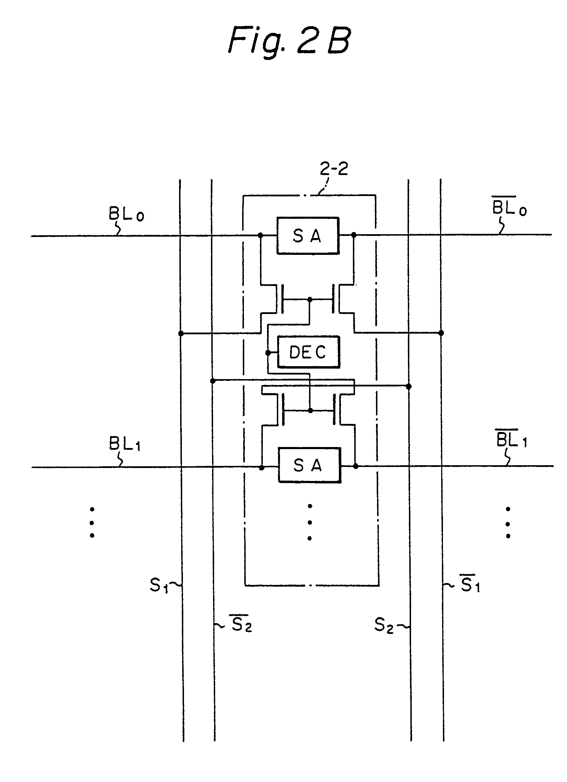

As illustrated in Fig. 2A, the sense amplifier/column decoder portion 2-1 comprises 256 sense amplifiers SA each provided for one bit line pair, and 128 column address decoders DEC each provided for two bit line pairs. Similarly, as illustrated in Fig. 2B, the sense amplifier/column decoder portion 2-2 comprises 256 sense amplifiers SA each provided for one bit line pair, and 128 column address decoders DEC each provided for two bit line pairs. The column address decoders DEC respond to column address signals $A_0'$ and $\overline{A}_0'$ through $A_6'$ and $\overline{A}_6'$, to select one bit line pair.

In addition, two pairs of sense lines $S_1$ and $\overline{S}_1$, $S_2$ and $\overline{S}_2$ corresponding to column address signals $A_7'$ and $\overline{A}_7'$ are provided for each of the blocks $BK_1$ and $BK_2$. As illustrated in Figs. 2A and 2B, the sense line $S_1$ (or $\overline{S}_1$) is connected via the portion 2-1 or 2-2 to bit lines $BL_0$, $BL_2$, ..., and $BL_{254}$ (or bit lines $\overline{BL}_0$, $\overline{BL}_2$, ..., and $\overline{BL}_{254}$), while the sense line $S_2$ (or $\overline{S}_2$) is connected via the portion 2-1 or 2-2 to bit lines $BL_1$, $BL_3$, ..., and $BL_{255}$ (or bit lines $\overline{BL}_1$, $\overline{BL}_3$, ..., and $\overline{BL}_{255}$).

In order to perform a write operation and a read operation upon a memory cell via the first pair of sense lines $S_1$ and $\overline{S}_1$, a write amplifier 4-1 and a sense buffer 5-1 are provided. Similarly, in order to perform a write operation and a read operation upon a memory cell via the second pair of the sense lines $S_2$ and $\overline{S}_2$, a write amplifier 4-2 and a sense buffer 5-2 are provided. The selection of the write amplifiers 4-1 and 4-2 is carried by a selector 6 using the column address signals $A_7'$ and $\overline{A}_7'$. The selection of the sense buffers 5-1 and 5-2 is carried out by a selector 7 using the column address signals $A_7'$ and $\overline{A}_7'$.

Note that reference $D_{in}$ designates an input data signal and $D_{out}$ designates an output data signal.

According to the present invention, the first pair of sense lines $S_1$ and $\overline{S}_1$ are arranged in the same way for each of the blocks $BK_1$ and $BK_2$, while the arrangement of the second pair of sense lines $S_2$ and $\overline{S}_2$ in the block $BK_1$ is different from that in the block $BK_2$.

Therefore, in the sense line $S_2$, the noise due to the sense line $S_1$ of the block $BK_1$ adjacent to the sense line $S_2$ is opposite in sense to the noise due to the sense line $\overline{S}_1$ of the block $BK_2$ adjacent to the sense line $S_2$, and these noises contradict each other. Similarly, in the sense line $\overline{S}_2$, the noise due to the sense line $\overline{S}_1$ of the block $BK_1$ adjacent to the sense line $\overline{S}_2$ is opposite in sense to the noise due to the sense line $S_1$ of the block $BK_2$ adjacent to the sense lines $\overline{S}_2$, and these noises contradict each other. Also, in the sense lines $S_1$ and $\overline{S}_1$, the noises due to the sense lines $S_2$ and $\overline{S}_2$ contradict each other.

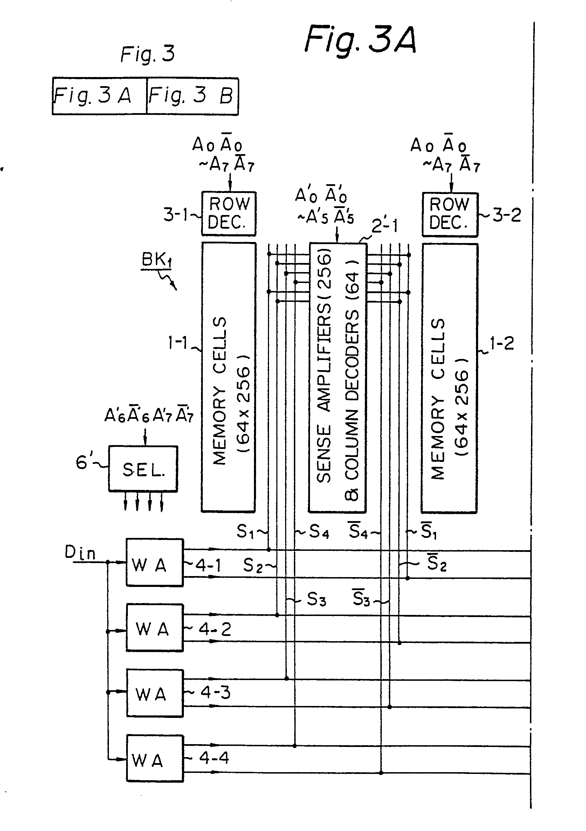

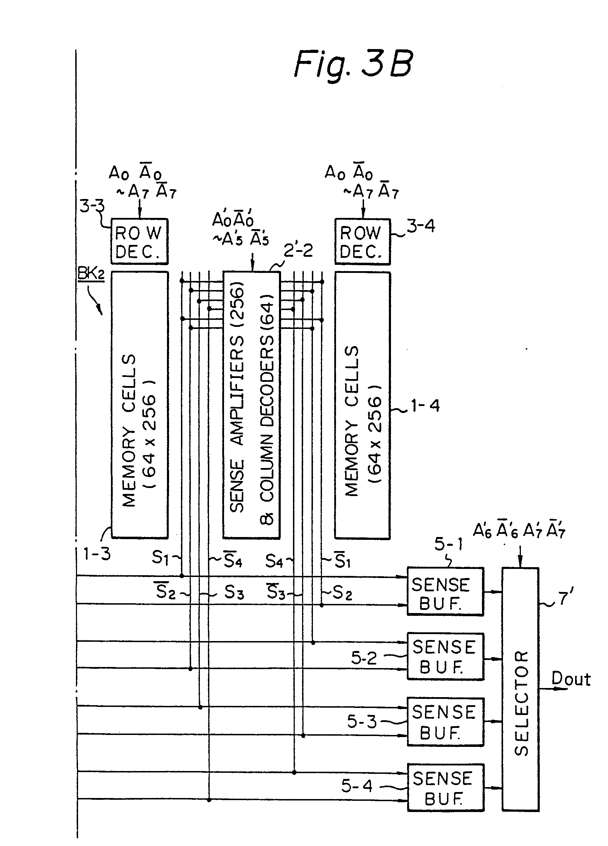

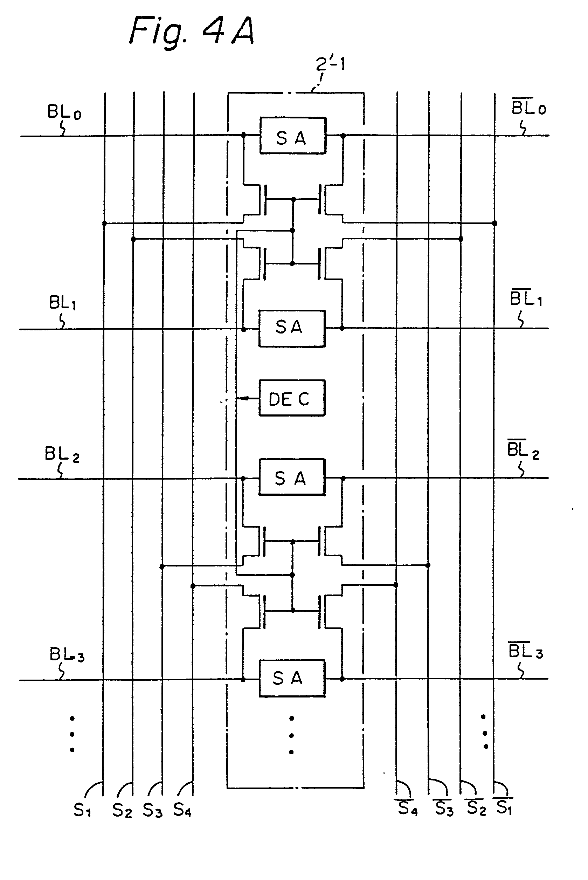

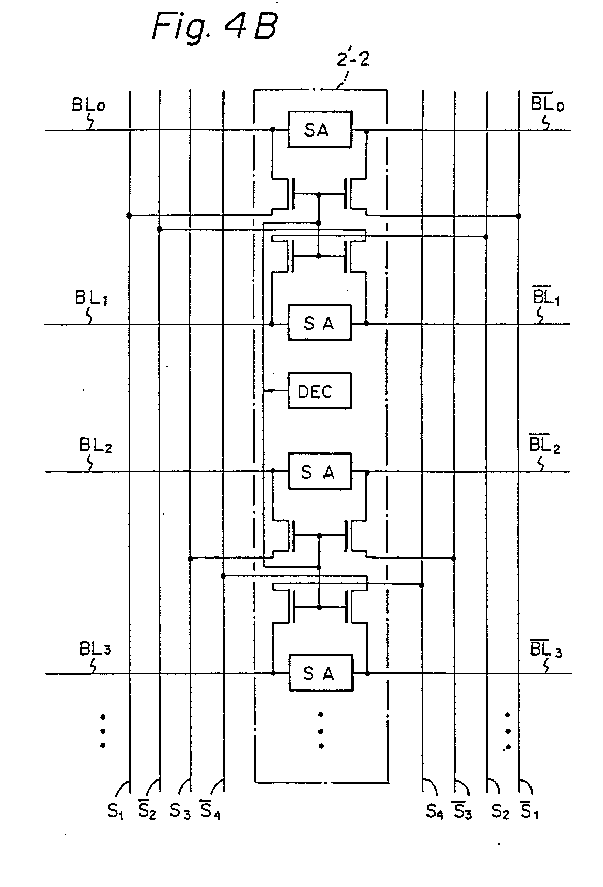

In Fig. 3, which illustrates a second embodiment of the present invention, four pairs of sense lines $S_1$ and $\overline{S}_1$; $S_2$ and $\overline{S}_2$; $S_3$ and $\overline{S}_3$; and $S_4$ and $\overline{S}_4$ are provided. In this case, as illustrated in Figs. 4A and 4B, the portion 2'-1 (or 2'-2) comprises 64 column address decoders DEC each provided for four pairs of bit lines. In this case, the column address decoders DEC respond to the column address signals $A_0'$ and $\overline{A}_0'$ through $A_5$ and $\overline{A}_5'$. In addition, two more write amplifiers 4-3 and 4-4 and two more sense buffers 5-3 and 5-4 are added to Fig. 1. A selector 6' responds to the column address signals $A_6$, $\overline{A}_6$, $A_7$, and $\overline{A}_7$ to select one of the write amplifiers 4-1 through 4-4, and a selector 7' responds to the column address signals $A_6'$, $\overline{A}_6'$, $A_7'$, and $\overline{A}_7'$ to select one of the sense buffers 5-1 through 5-4.

In the first block $BK_1$ shown in Fig. 3, the sense lines $S_1$, $S_2$, $S_3$, $S_4$, $\overline{S}_4$, $\overline{S}_3$, $\overline{S}_2$, and $\overline{S}_1$ are arranged in this order, while in the second block $BK_2$, the sense lines $S_1$, $\overline{S}_2$, $S_3$, $\overline{S}_4$, $S_4$, $\overline{S}_3$, $S_2$, $\overline{S}_1$ are arranged in this order (see also Figs. 4A and 4B). Therefore, also in this case, in one sense line such as $S_2$, the noise due to the sense line $S_1$ or $S_3$ of the block $BK_1$ adjacent to the sense line $S_1$ contradicts the noise due to the sense line $\overline{S}_1$ or $\overline{S}_3$ of the block $BK_2$ adjacent to the sense line $S_2$.

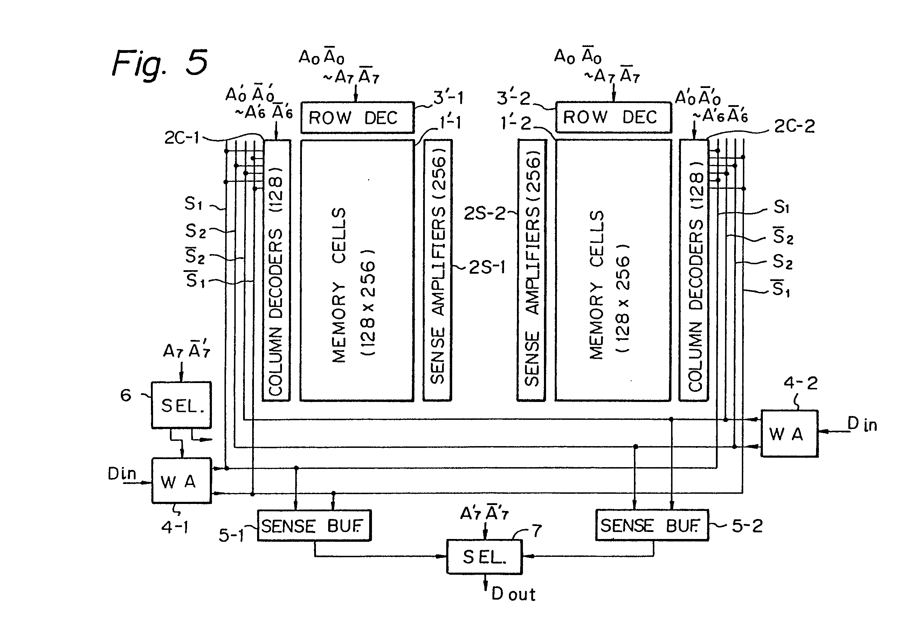

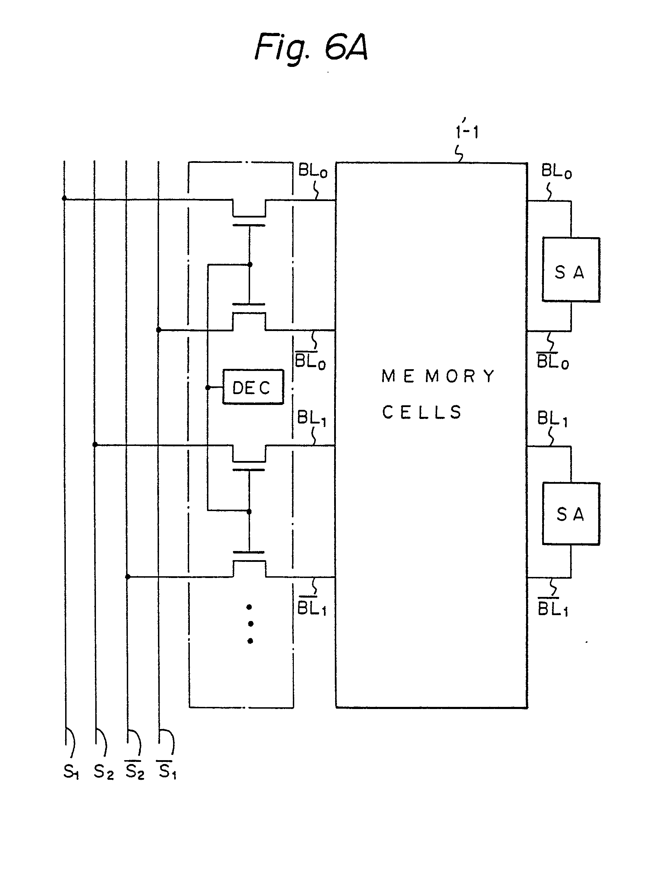

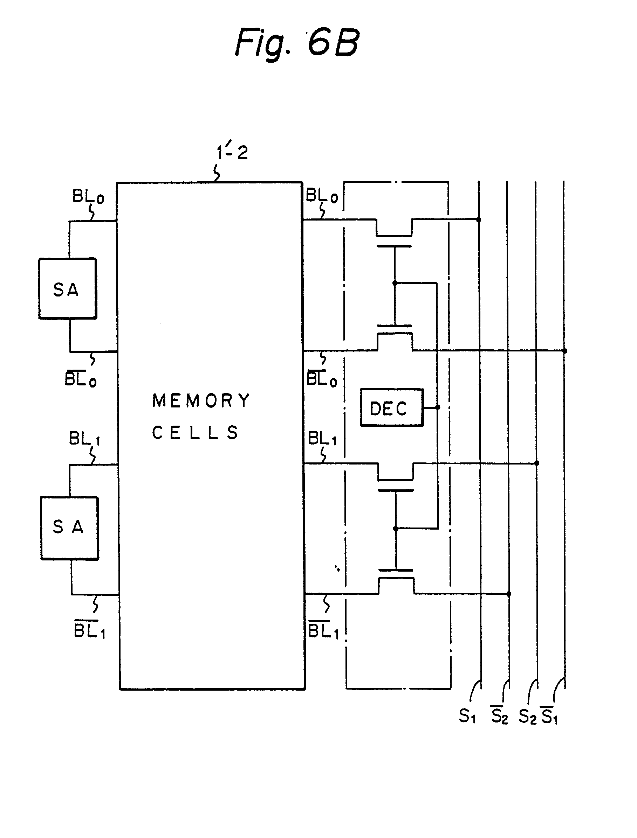

In Fig. 5, which illustrates a third embodiment of the present invention, folded bit lines are arranged on one side of a sense amplifier series, as illustrated in Figs. 6A and 6D. Note that the embodiments shown in Figs. 1 and 3 use opened bit lines arranged on both sides of a sense amplifier series. In Fig. 5, sense amplifiers 2S-1 and column address decoders 2C-1 correspond to the portion 2-1 shown in Fig. 1, and sense amplifiers 2S-2 and column address decoders 2C-2 correspond to the portion 2-2 shown in Fig. 1. In addition, row address decoders 3'-1 correspond to the combination of the decoders 3-1 and 3-2, shown in Fig. 1, the row address decoders 3'-2 correspond to the combination of the decoders 3-3 and 3-4. In this case, the arrangement of the sense lines $S_1$, $\overline{S}_1$, $S_2$, and $\overline{S}_2$ are the same as that shown in Fig. 1, thereby obtaining the same effect as in the embodiment shown in Fig. 1.

Note that the present invention can be also applied to the case where memory cells are divided into four or more blocks. For example, in the case of a four-block-divided device having four pairs of sense lines $S_1$ and $\overline{S}_1$; $S_2$ and $\overline{S}_2$; $S_3$ and $\overline{S}_3$; and $S_4$ and $\overline{S}_4$, the sense lines $S_1$, $S_2$, $S_3$, $S_4$, $\overline{S}_4$, $\overline{S}_3$, $\overline{S}_2$, and $\overline{S}_1$ are arranged in this order for two of the blocks, and the sense lines $S_1$, $\overline{S}_2$, $S_3$, $\overline{S}_4$, $S_4$, $\overline{S}_3$, $S_2$, and $\overline{S}_1$ are arranged in this order for the other two blocks.

As explained hereinbefore, according to the present invention, the noise due to the interaction between the sense lines is reduced, thereby obtaining a correct read operation carried out simultaneously with a write operation.

**Claims**

1. A semiconductor memory device comprising:

a plurality of word lines;

a plurality of pairs of bit lines (BL$_0$, $\overline{BL}_0$, ..., BL$_{255}$, $\overline{BL}_{255}$);

memory cells (1-1 to 1-4, 1'-1, 1'-2) each provided at an intersection of the word lines and the bit lines, the memory cells being divided into a plurality of blocks (BK$_1$, BK$_2$) separated from each other;

a plurality of pairs of sense lines (S$_1$, $\overline{S}_1$; ...; S$_4$, $\overline{S}_4$) provided for each of the blocks, each pair receiving two complementary signals;

a first selecting means (3-1 to 3-4, 3'-1, 3'-2) for selecting one word line from the word lines;

a second selecting means (2-1, 2-2, 2C-1, 2C-2) for selecting a plurality of pairs of bit lines from the bit lines belonging to each block, and to connect the selected pairs of bit lines to the pairs of sense lines of the corresponding block; and,

a third selecting means (6, 7, 6', 7') for selecting one pair from the pairs of sense lines;

characterised in that the sense relationship between two adjacent sense lines (S$_1$, S$_2$) belonging to one block (BK$_1$) is opposite to the sense relationship between the corresponding two adjacent sense lines (S$_1$, $\overline{S}_2$) belonging to the other block (BK$_2$) to which they are directly connected.

2. A device according to claim 1, wherein the bit lines are of an opened type (Figures 1 and 3).

3. A device according to claim 1, wherein the bit lines are of a folded type (Figures 6A and 6B).

## Patentansprüche

1. Halbleiterspeichervorrichtung mit:

einer Vielzahl von Wortleitungen;

einer Vielzahl von Paaren von Bitleitungen (BL$_0$, $\overline{BL}_0$, BL$_{255}$, $\overline{BL}_{255}$);

Speicherzellen (1-1 bis 1-4, 1'-1, 1'-2) die jeweils an einem Schnittpunkt der Wortleitungen und Bitleitungen vorgesehen sind, wobei die Speicherzellen in einen Vielzahl von Blöcken (BK$_1$, BK$_2$) unterteilt sind, die voneinander getrennt sind;

einer Vielzahl von Paaren von Leseleitungen (S$_1$, $\overline{S}_1$..., S$_4$, $\overline{S}_4$), die für jeden der Blöcke vorgesehen sind, wobei jedes Paar zwei komplementäre Signale empfängt;

einer ersten Auswahleinrichtung (3-1 bis 3-1, 3'-2), zum Auswählen einer Wortleitung von den Wortleitungen;

einer zweiten Auswahleinrichtung (2-1, 2-2, 2C-2, 2C-2) zum Auswählen einer Vielzahl von Paaren von Bitleitungen von den Bitleitungen, die zu jedem Block gehören, und um die ausgewählten Paare von Bitleitungen mit den Paaren von Leseleitungen des entsprechenden Blockes zu verbinden; und

einer dritten Auswahleinrichtung (6, 7, 6', 7'), zum Auswählen eines Paares von den Paaren von Leseleitungen;

dadurch gekennzeichnet, daß die Leserelation zwischen zwei benachbarten Leseleitungen (S$_1$, S$_2$) die zu einem Block (BK$_1$) gehöhren, entgegengesetzt zu der Leserelation zwischen den entsprechenden beiden benachbarten Leseleitungen (S$_1$, $\overline{S}_2$) ist, die zu dem anderen Block (BK$_2$) gehören, mit dem sie direkt verbunden sind.

2. Vorrichtung nach Anspruch 1, bei der die Bitleitungen von einem geöffneten Typ (Figuren 1 und 3) sind.

3. Vorrichtung nach Anspruch 1, bei der die Bitleitungen von einem gefalteten Typ (Figuren 6A und 6B) sind.

## Revendications

1. Dispositif de mémoire à semiconducteur comprenant:

un ensemble de fils de mot;

un ensemble de paires de fils de bit (BL$_0$, $\overline{BL}_0$, ..., BL$_{255}$, $\overline{BL}_{255}$);

des cellules de mémoire (1-1 à 1-4, 1'-1, 1'-2) prévues chacune à une intersection des fils de mot et des fils de bit, les cellules de mémoire étant divisées en un ensemble de blocs (BK$_1$, BK$_2$) séparés entre eux;

un ensemble de paires de fils de détection (S$_1$, $\overline{S}_1$;..., S$_4$, $\overline{S}_4$) prévues pour chacun des blocs, chaque paire recevant deux signaux complémentaires;

un premier moyen de sélection (3-1 à 3-4, 3'-1, 3'-2) pour sélectionner un fil de mot parmi les fils de mot;

un deuxième moyen de sélection (2-1, 2-2, 2C-1, 2C-2) pour sélectionner un ensemble de paires de fils de bit parmi les fils de bit appartenant à chaque bloc, et pour connecter les paires sélectionnées de fils de bit aux paires de fils de détection du bloc correspondant; et,

un troisième moyen de sélection (6, 7, 6', 7') pour sélectionner une paire parmi les paires de fils de détection;

caractérisé en ce que le rapport des sens entre deux fils de détection voisins (S$_1$, S$_2$) appartenant à un bloc (BK$_1$) est inverse du rapport des sens entre les deux fils de détection voisins (S$_1$, $\overline{S}_2$) correspondant appartenant à l'autre bloc (BK$_2$) auquel ils sont directement connectés.

2. Dispositif selon la revendication 1, dans lequel les fils de bit sont d'un type ouvert (Figures 1 et 3).

3. Dispositif selon la revendication 1, dans lequel les fils de bit sont d'un type replié (Figures 6A et 6B).

0 115 128

Fig. I A

Fig. I

| Fig. I A | Fig. I B |

$A_0 \bar{A}_0 \sim A_7 \bar{A}_7$

ROW DEC. 3-1

BK₁

MEMORY CELLS (64 x 256) 1-1

$\acute{A}_7 \bar{A}'_7$

6 SEL

$A'_0 \bar{A}'_0 \sim A'_6 \bar{A}'_6$

SENSE AMPLIFIERS (256) & COLUMN DECODERS (128) 2-1

$A_0 \bar{A}_0 \sim A_7 \bar{A}_7$

ROW DEC. 3-2

MEMORY CELLS (64 x 256) 1-2

$S_1$ $S_2$ $\bar{S}_1$ $\bar{S}_2$

Din WA 4-1

SENSE BUF. 5-1

$\acute{A}'_7 \bar{A}'_7$

7 SEL.

Dout

0 115 128

Fig. 1 B

2

# Fig. 2A

# Fig. 2 B

# Fig. 3

| Fig. 3 A | Fig. 3 B |
|----------|----------|

# Fig. 3A

# Fig. 3B

# Fig. 4 A

# Fig. 4B

Fig. 5

# Fig. 6A

# Fig. 6B